(19) Europäisches Patentamt
European Patent Office
Office européen des brevets

(11) Publication number: 0 042 926
A1

(12) EUROPEAN PATENT APPLICATION

(21) Application number: 81103060.0

(22) Date of filing: 23.04.81

(51) Int. Cl.³: H 01 L 21/90
H 01 L 23/52

(30) Priority: 01.07.80 US 164998

(43) Date of publication of application:
06.01.82 Bulletin 82/1

(84) Designated Contracting States:
DE FR GB IT

(71) Applicant: Rockwell International Corporation
2230 East Imperial Highway
El Segundo, California 90245(US)

(72) Inventor: Custode, Frank Zuckov
4532 Palamino Lane
Norco California 91760(US)

(72) Inventor: Sarace, John Carl
38440 Via Vista Grande
Temecula California 92390(US)

(74) Representative: Wagner, Karl H., Dipl.-Ing.
P.O.Box 22 02 46 Gewuerzmuehlstrasse 5
D-8000 München 22(DE)

# (54) Aluminum to aluminum ohmic contacts, multilevel interconnections.

(57) The invention comprises a method and apparatus exhibiting improved ohmic contacts between aluminum metallization layers fabricated in the manufacture of a chip. The chip comprises at least one layer of aluminum metallization including calcium, cesium, or magnesium as a minor constituent thereof. Intimate contacts are formed between the metallization layers because these minor constituents react with the aluminum oxide and eliminate the electrical aluminum oxide barrier between the contacts to insure intimate contact with the metallization layers.

EP 0 042 926 A1

Croydon Printing Company Ltd.

0042926

# Aluminum to Aluminum Ohmic Contacts, Multilevel Interconnections

## Field of the Invention

The invention relates to the manufacture of semiconductor chips including metallization layers, and to the product thereof having improved ohmic contacts between said layers.

## Background Art

No prior art is known.

## Brief Description of the Invention

The invention comprises a novel product for improving the ohmic contacts between aluminum metallization layers fabricated onto a chip during processing. At least one of the elements calcium, cesium and magnesium selected from Group IIa of the Periodic Table having the potential to reduce aluminum oxide is added to the aluminum comprising at least one of said metallization layers, such that the exothermic heat of reaction to the added minor constituent and the aluminum oxide is sufficient to get rid of the aluminum oxide barrier and cause intimate aluminum to aluminum film contact for lower resistance connections. The aluminum adjacent the silicon oxide of a silicon substrate may include silicon for better binding and the addition of from 0.2 to 10 percent of the magnesium minor constituent is sufficient to generate sufficient heat of reaction for the purposes herein intended without interfering with the characteristics of the aluminum.

## Brief Description of the Drawing

A single figure illustrates two layers of aluminum metallization on a silicon substrate with metallization contact.

Description of a Preferred Embodiment

In the preferred embodiment, of the order of one percent magnesium is added to the aluminum to provide the desirable characteristics of the subject invention.

The uses, advantages and examples of fabrication for the process and product follow hereinafter.

In order to exploit fully the increased density and performance attainable by VLSI geometries (<3 microns), it is shown that a multilevel process provides less stringent requirements on metal width and spacing and allows greater flexibility and density in circuit layout designs. In addition, RC losses resulting from increased line resistance are reduced, thereby improving performance.

The use of aluminum as the interconnect metal for IC fabrication is widespread throughout the industry and is preferred by manufacturers because of its simplicity, cost effectiveness, and reliability. The development of an all aluminum multilevel metal has not been commercially realized, primarily because of the native oxide formed between first level and second level metal. This film of aluminum oxide prevents consistent reliable ohmic contact between aluminum films. Aluminum does, however, make excellent contact to silicon for two reasons -- first, adequate solid solubility in silicon and second, the ability to react with silicon dioxide at sintering temperatures, according to the reaction:

$$3\ SiO_2 + 4\ Al \quad 3\ Si + 2\ Al_2O_3 + 220\ \text{millijoules/Kmole}\ SiO_2$$

This strong exothermic reaction dissolves the thin film of $SiO_2$ between the silicon and aluminum, thereby insuring consistently good contacts normally achieved with aluminum. One can apply this same approach to aluminum-aluminum contacts by incorporating an element which will react with $Al_2O_3$ in the metal film.

Thermodynamic Considerations

Assuming the reaction between a metal and an oxide takes place at constant temperature and pressure, the change in Gibbs free energy, $\Delta G$, is given by

$$\Delta G = \Delta H - T\Delta S$$

where $\Delta H$ is the change in enthalpy (heat of reaction at temp T) and $\Delta S$ is the change in entropy. For the case of temperature ranges not to exceed 450°C at one atmosphere and the metals under consideration, no volume or phase changes are anticipated on reactants or products, thus $\Delta S \approx 0$. The change in free energy $\Delta G$ is thus approximated by a change in enthalpy $\Delta H$ during the reaction. If $\Delta H$ is negative, the reaction is thermodynamically possible, and the magnitude is a measure of the spontaneity of the reaction.

A survey of the thermodynamic data was made to determine if certain elements would undergo an exchange reaction with oxides of aluminum; and if so, would the system be of practical value for the intended application, i.e., lower contact resistance between aluminum layers. Table I lists the standard free-energy of formation values ($\Delta F_f o$) in Kcal/g-mole of various metal oxides considered to be possible candidates for this application.

Table I.

| Element | Compound | Oxide $\Delta F_{f°}$ | $\Delta F_{450°C}$ |
|---|---|---|---|
| Al | $Al_2O_3$ | -377 | -339 |
| Si | $SiO_2$ | -192 | -174 |
| Ce | $Ce_2O_3$ | -230 | -378 |
| $H_f$ | $H_fO_2$ | -270 | -230 |
| Mn | MnO | - 87 | - 78 |
| | $MnO_2$ | -111 | - |
| Mg | MgO | -136 | -125 |
| Ca | CaO | -144 | -132 |
| B | $B_2O_3$ | -283 | -255 |

From these values, the heat of reaction can be calculated at sintering temperature (450°C) for various metal oxide systems. For example, the reaction between Al and $SiO_2$ proceeds as follows:

$$4\ Al + 3\ SiO_2 \rightarrow 2\ Al_2O_3 + 3\ Si$$

$$4(0) + 3\ (-174) \quad 2(-377) + 3(0)$$

$$\Delta F = -232\ Kcal/mole$$

Because ΔF is negative, this reaction is thermodynamically expected to occur. Heats of reaction were calculated using the data from Table I assuming a reaction between aluminum oxide and the element. These results are shown in Table II.

Table II.

| Element | Oxide | ΔF Kcal/9 mole |
|---|---|---|
| Ca | CaO | - 57 |
| Ce | $Ce_2O_3$ | - 39 |
| Mg | MgO | - 30 |
| $H_f$ | $H_fO_2$ | + 12 |
| B | $B_2O_3$ | + 84 |
| Mn | MnO | +105 |

The upper three elements (from Group IIa of the Periodic Table) have the potential to reduce aluminum oxide. Their use in a metal system, however, will depend upon favorable metallurgy using aluminum. Some insight into the selection of an alloy system can be obtained by examining the physical properties of the elements and the binary phase diagrams. This study reveals that Al-Ca, Al-Ce, and Al-Mn form strong intermetallic compounds and exhibit virtually no solid solubility range. An Al-Mg system does have solid solubility (≈10% Mg in Al). Moreover, the intermetallic phases β and γ were difficult to detect, suggesting that the heat of formation is low enough not to inhibit the desired reaction with the oxide. Mg was selected as a test alloy with aluminum in the following example because of these reasons and the ready access of Al Mg alloys.

Example:

The alloy composition chosen for experimentation was aluminum, 1 wt % Mg. The alloy was obtained at 99.999% purity. Films were deposited from this source by d-c sputtering techniques at 1 micron pressure in argon. The test vehicle used to evaluate contact reliability was the contact portion of the process integrity chip used to evaluate aluminum to silicon contacts. This array has provisions for a total of 14,400 contacts arranged in a series string. Electrical tap offs are provided to enable integration at progressively larger numbers of contacts. The samples were prepared in

following manner:

A thermal oxide of approximately 7000 angstroms was grown on 3 inch p-type silicon wafers. This silicon oxide serves as an insulating layer to the bulk substrate. Next, a layer of 8000 angstroms of aluminum-silicon (1%) was sputtered on top of the oxide. This metal layer was then patterned and etched. After cleaning (i.e., stripping resist, etc.), a layer of 4000 angstroms of aluminum-magnesium (1%) was deposited. Next, a sintering step at 500°C in forming gas was performed. Then the second level of metallization was patterned and etched.

The resulting structure exhibited roughness of the aluminum-magnesium film. This texture is believed to result from the condition of deposition rather than a property of the alloy. This structure is the most simple and direct way of enlisting metal-to-metal contact resistance by eliminating other variables, such as residues left from the insulating oxide, photoresist, etc.

The overall contact area was 3 x 3 micrometers and the contact resistance was estimated to be less than 0.1Ω per contact.

A preferred embodiment of the present invention is pictured in the single figure, wherein a p-type wafer of silicon 1 has a silicon oxide layer 3 formed thereon and patterned to leave an opening 5 to the surface of the silicon. Next a layer of aluminum magnesium silicon 7 was sputtered over the layer 3 to provide contact to the silicon through the opening 5.

Next, a dielectric layer 9 is laid down over layer 7 and comprises, for example, polyimide. This layer was patterned to leave the opening 11 to the metallization layer 7.

Fianlly, a cross connector 13 of aluminum magnesium was laid down in the area of opening 11 to establish the aluminum oxide-free contact 3 connection between layers 13 and 7 due to the magnesium of either layer reacting with the aluminum oxide during sintering to create the exothermic heat which removes the aluminum oxide film to permit the intimate contact or low ohmic junction

provided by this invention.

Several wafers were tested for continuity. These wafers came from different lots processed at different times. On the test wafers, the percentage of completed contacts was substantially higher than without magnesium additives to the aluminum.

Uniformity within a wafer and from wafer to wafer is very good. The measured resistance for the entire chain is approximately 60Ω. From this one can calculate the amount of contact resistance to be less than 0.1 Ω. This may be contrasted with unreliable contacts exhibiting up to several hundred ohms. The two lots processed have shown excellent and repeatable results.

The ease of implementation and the process compatibility with standard processes makes this process extremely attractive for double metallization procedures on VLSI.

What is Claimed Is:

## Claims

1. The method of improving ohmic contacts between aluminum metallization layers in the fabrication of a chip, comprising the steps of:

adding at least one of calcium, cesium, and magnesium to aluminum to comprise at least one of said layers;

forming contacts between the metallization layers; and

sintering the metallization layers to eliminate the aluminum oxide barrier between the contacts.

2. The method of Claim 1, wherein:

magnesium is added to the material of at least one of said layers.

3. The method of Claim 2, wherein:

magnesium is added to the approximate extent of 0.2 to 10 percent by weight.

4. The method of Claim 3, wherein:

the magnesium is alloyed with the aluminum using approximately one percent magnesium; and,

the elimination of said aluminum oxide is accomplished by the reaction between the magnesium and $Al_2O_3$.

5. The method of Claim 4, wherein:

said chip is silicon and a layer of aluminum metallization adjacent the oxidized surface of silicon includes both magnesium and silicon.

6. A chip having improved ohmic contact between metallization layers, comprising in combination:

a metal system of primarily aluminum on said chip;

said system comprising multiple level aluminum metallization layers;

at least one of said layers including as a lesser part thereof, magnesium;

intimate contacts between said layers; and,

said contacts being free of any aluminum oxide barrier as a result of exothermic heat of reaction between the aluminum oxide and the magnesium.

7. The chip of Claim 6, wherein;

said magnesium comprises approximately 0.2 to 10 percent by weight of the aluminum of at least one layer.

8. The chip of Claim 7, wherein;

said chip is silicon and a layer of aluminum metallization adjacent an oxidized surface of silicon includes both magnesium and silicon.

9. A semiconductor chip having improved ohmic contacts fabricated between aluminum metallization layers thereof, comprising in combination;

multiple layers of aluminum metallization formed on the chip with at least one layer including one of calcium, cesium, and magnesium as a minor constituent thereof;

intimate contacts formed between the aluminum layers; and said contacts being free of any aluminum oxide barrier as a result of exothermic heat of reaction between the aluminum oxide and said calcium, cesium, or magnesium.

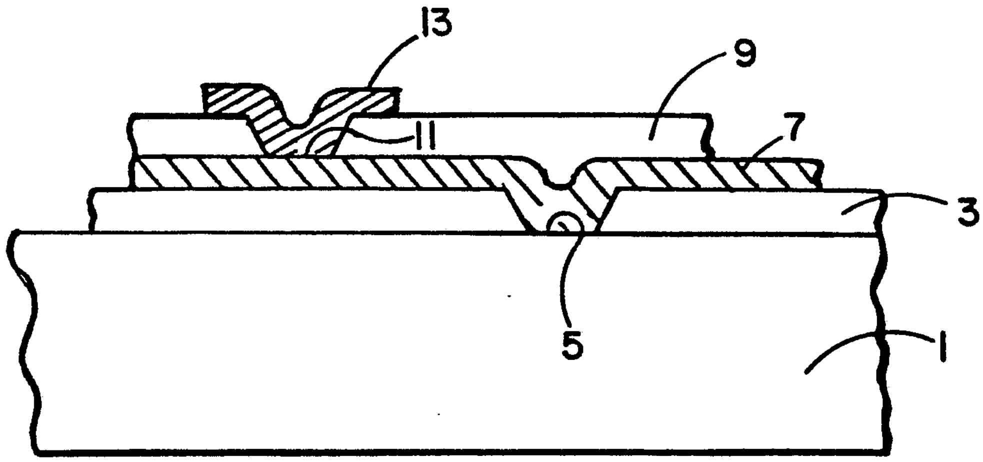
13
9
11
7
3
5
1

0042926

Application number

European Patent Office

# EUROPEAN SEARCH REPORT

EP 81 10 3060.0

| DOCUMENTS CONSIDERED TO BE RELEVANT | | | CLASSIFICATION OF THE APPLICATION (Int. Cl.³) |
|---|---|---|---|
| Category | Citation of document with indication, where appropriate, of relevant passages | Relevant to claim | |
| | FR - A1 - 2 428 915 (FUJITSU)<br>* claim 1; page 4, line 34 to page 5, line 29 *<br>--- | 1 | H 01 L 21/90<br>H 01 L 23/52 |
| | "Soviet Inventions Illustrated"<br>Week B 33, 27 Sept 79<br>Section L03 M26<br>& SU - A - 544703<br>--- | 1 | |
| | | | TECHNICAL FIELDS SEARCHED (Int. Cl.³) |
| A | US - A - 4 143 802 (WINTERBOTTOM)<br>* claims 1, 2; column 2, lines 12 to 35 *<br>--- | | B 22 F 7/00<br>B 23 K 1/19<br>B 23 K 5/14<br>B 23 K 20/22<br>C 22 C 21/06<br>H 01 L 21/88<br>H 01 L 23/48<br>H 01 L 23/52<br>H 01 L 29/40 |
| A | US - A - 4 164 461 (SCHILLING)<br>* column 4, line 8 to column 5, line 17 *<br>---- | | |
| | | | CATEGORY OF CITED DOCUMENTS<br>X: particularly relevant<br>A: technological background<br>O: non-written disclosure<br>P: intermediate document<br>T: theory or principle underlying the invention<br>E: conflicting application<br>D: document cited in the application<br>L: citation for other reasons |
| X | The present search report has been drawn up for all claims | | &: member of the same patent family, corresponding document |

| Place of search | Date of completion of the search | Examiner |
|---|---|---|
| Berlin | 28-09-1981 | GIBBS |